Europäisches Patentamt

European Patent Office

Office européen des brevets

(19)

(11) Publication number: **0 190 469**
**A1**

## (12) EUROPEAN PATENT APPLICATION

(21) Application number: **85202061.9**

(22) Date of filing: **13.12.85**

(51) Int. Cl.⁴: **H 03 F 3/45**

(30) Priority: **15.01.85 NL 8500080**

(43) Date of publication of application:
**13.08.86 Bulletin 86/33**

(84) Designated Contracting States:
**BE DE FR GB IT NL**

(71) Applicant: **N.V. Philips' Gloeilampenfabrieken
Groenewoudseweg 1
NL-5621 BA Eindhoven(NL)**

(72) Inventor: **van Mil, Job Franciscus Petrus
c/o INT. OCTROOIBUREAU B.V. Prof. Holstlaan 6
NL-5656 AA Eindhoven(NL)**

(72) Inventor: **Slomp, Albert Hendrikus
c/o INT. OCTROOIBUREAU B.V. Prof. Holstlaan 6
NL-5656 AA Eindhoven(NL)**

(72) Inventor: **Bierhoff, Martinus Petrus Maria
c/o INT. OCTROOIBUREAU B.V. Prof. Holstlaan 6
NL-5656 AA Eindhoven(NL)**

(72) Inventor: **Schoofs, Franciscus Adrianus C. M.
c/o INT. OCTROOIBUREAU B.V. Prof. Holstlaan 6
NL-5656 AA Eindhoven(NL)**

(74) Representative: **Peters, Rudolf Johannes et al,
INTERNATIONAAL OCTROOIBUREAU B.V. Prof.
Holstlaan 6
NL-5656 AA Eindhoven(NL)**

(54) Transconductance amplifier.

(57) If in integrated filter circuits comprising transconductors and capacitors transconductance amplifiers with comparatively low transconductances are employed, only comparatively small capacitors need to be integrated. A transconductance amplifier with a comparatively low transconductance comprises a first transistor ($T_1$) and a second transistor ($T_2$), which are arranged as a differential pair and whose commoned emitters (3) are connected to a current source (4). An input voltage ($v_i$) is applied between the bases of the first transistor and the second transistor ($T_1$, $T_2$). The collector current ($I_1$) of the first transistor ($T_1$) is applied to a current dividing circuit (9), which divides this current in a ratio 1:a into a first current ($I_3$) and a second current ($I_4$). Similarly, the collector current ($I_2$) of the second transistor ($T_2$) is divided in a ratio 1:a into a third current ($I_5$) and a fourth current ($I_6$). The fourth current ($I_6$) and the first current ($I_3$) constitute the first output current ($I_7$) and the second current ($I_4$) and the third current ($I_5$) constitute the second output current ($I_8$).

FIG.1

Transconductance amplifier.

The invention relates to a transconductance amplifier comprising at least two transistors which are arranged as a differential amplifier and which are powered by a current source, in which an input voltage is applied between the bases of said transistors and the currents in the collectors of said transistors constitute the output currents of the amplifier.

Such transconductance amplifiers or, briefly, transconductors, may be used in, for example, integrated filter circuits comprising transconductors and capacitors. A transconductor can perform the function of a resistor and two transconductors may be arranged as a gyrator which in combination with a capacitor can perform the function of an inductance. Therefore, any filter circuit comprising conventional coils, capacitors and resistors can also be realised by means of transconductors and capacitors. In particular, such transconductors may be used in integrated filter circuits intended for use in a high-frequency equalising circuit of a compact-disc player.

A transconductor is a voltage-controlled current source in which the proportionality factor between the output current and the input voltage is given by the transconductance G. The simplest transconductor is a differential amplifier by means of which a voltage applied between the bases is converted into two collector currents of opposite phase. The transconductance of such a differential amplifier is proportional to the current of the current source which powers the differential amplifier. In many cases the current of this current source cannot be made arbitrarily small for reasons of circuit design. As a result of this, the transconductance of the amplifier is comparatively high and, consequently, the resistance to be realised $(R = 1/G)$ is relatively low. This relatively
high transconductance means that comparatively high
capacitances are required in order to obtain the time
constants necessary for a specific filter characteristic.
Integrating these capacitances demands comparatively large
surface areas, which renders the integrated circuit
expensive.

Therefore, it is desirable to have comparatively
low transconductances in order to minimize the capacitances
required for a specific filter response and hence the
integration area needed for these capacitances. The article
"Bipolar Integration of Analog Gyrator and Laguerre-type
Filters (Transconductor-capacitor filters) in Proceedings
ECCTD 1983, pp. 109-110 describes a transconductor of the
type specified in the opening paragraph, which has a
relatively low transconductance. In this circuit a fractionn
of the total input voltage is applied to the actual inputs
of the transconductor by means of a resistive voltage
divider. This results in a reduction of the effective
transconductance, so that lower capacitances and consequently
smaller integration areas are needed for a given filter
response.

A disadvantage of this known transconductor is that
the voltage-divider resistors can be integrated only with
limited accuracy, which restricts the accuracy and
frequency range of the voltage divider. Moreover, a comparatively large integration area is needed for the resistors,
in particular for the resistors of high value.

It is the object of the invention to provide a
simple transconductance amplifier which has a relatively low
transconductance. According to the invention a transconductance amplifier of the type defined in the opening paragraph
is characterized in that the collector currents are each
divided into a first current and a second current by means of
a current dividing circuit and the second currents are added
crosswise to the first currents.

The invention is based on the recognition of the following fact. Apart from an identical direct current, the two collector currents each contain a signal current of equal magnitude but opposite phase. By taking a fraction of each collector current and adding this to the other collector current, two signal currents of opposite phase are added to each other, so that the resulting signal current is smaller than the original collector signal current. The resulting direct current remains equal to the original collector direct current. As the signal current is reduced and the input voltage remains the same, the effective transconductance of the circuit is thus reduced.

An embodiment of the invention may be characterized in that the current dividing circuits each comprise two transistors with parallel-connected base-emitter junctions and a common emitter terminal which is connected to the collector of a transistor of the differential amplifier, the collector of one transistor of the current dividing circuit carrying the first current and the collector of the other transistor of the current dividing circuit carrying the second current. The ratio between the first current and the second current can be adjusted simply by means of the ratio between the emitter areas of the two transistors of such a current dividing circuit.

The invention will now be described in more detail, by way of example, with reference to the accompanying drawing, in which

Figure 1 is the basic diagram of a transconductance amplifier in accordance with the invention, and

Figure 2 shows a transconductance amplifier in accordance with a particular embodiment of the invention.

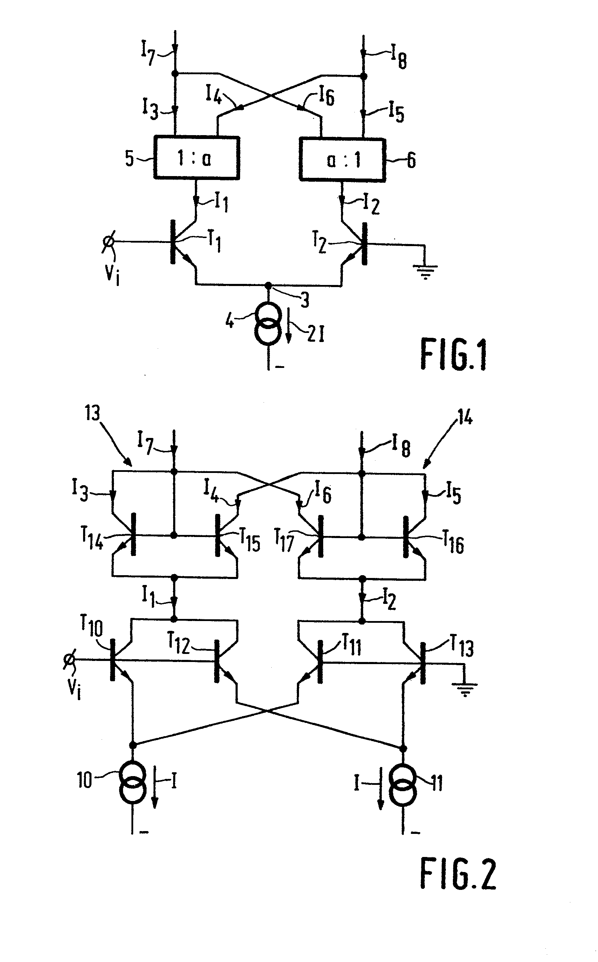

Fig. 1 is the basic diagram of a transconductance amplifier in accordance with the invention. The amplifier comprises two transistors $T_1$ and $T_2$ arranged as a differential pair and having their common-emitter terminal 3 connected to a current source 4 supplying a current 2I. In the quiescent state this current is equally divided between the transistors $T_1$ and $T_2$. When a signal voltage is applied between the bases of the transistors $T_1$ and $T_2$ a signal current i will flow in the collector of the transistor $T_1$ and a signal current -i in the collector of the transistor $T_2$. The total collector current of transistor $T_1$ is therefore equal to $I_1 = I + i$ and the total collector current of the transistor $T_2$ is $I_2 = I - i$. The collector of the transistor $T_1$ isconnected to the input of a current dividing circuit 5, shown schematically, which divides the collector current $I_1$ of transistor $T_1$ into two currents $I_3$ and $I_4$ which are in a ratio of 1:a. Similarly, the collector of the transistor $T_2$ is connected to a current dividing circuit 6, which divides the collector current $I_2$ of the transistor $T_2$ into two currents $I_5$ and $I_6$, which are also in a ratio of 1:a. The current $I_6$ is added to the current $I_3$ and the sum of these currents constitutes one output current $I_7$. In the same way the current $I_4$ is added to the current $I_5$ and the sum of these currents constitutes the other output current $I_8$. The current $I_7$ is equal to :

$$I_7 = I_3 + I_6 = (I + i)\ \frac{1}{1+a} + (I - i)\ \frac{a}{1+a} \qquad (1)$$

$$= I + i \cdot \frac{1-a}{1+a}$$

The current $I_8$ is equal to :

$$I_8 = I_4 + I_5 = (I + i)\ \frac{a}{1+a} + (I - i)\ \frac{1}{1+a}$$

$$= I - i \cdot \frac{1-a}{1+a} \qquad (2)$$

Equations 1 and 2 show that the signal currents are a factor $\frac{1-a}{1+a}$ smaller than the original signal currents and that the direct currents remain the same. Owing to the smaller signal current the transconductance of the circuit, which is given by the ratio between the output signal current and the input signal voltage, also becomes a factor $\frac{1-a}{1+a}$ smaller than the original transconductance.

When the circuit is employed in integrated filter circuits comprising transconductors and capacitors, the desired time constant of the filter circuit can be obtained using smaller capacitances which can be integrated on a smaller area, owing to the smaller transconductances.

Figure 2 shows a circuit in accordance with a particular embodiment of the invention. The transconductance amplifier comprises a first differential pair of transistors $T_{10}$ and $T_{11}$, whose common emitter terminal is connected to a current source 10 supplying a current I, which pair is arranged in parallel with a second differential pair comprising transistors $T_{12}$ and $T_{13}$, whose common emitter terminal is connected to a current source 11 supplying a current I. The collectors of the transistors $T_{10}$ and $T_{12}$ and the collectors of the transistors $T_{11}$ and $T_{13}$ are interconnected. The transistors $T_{10}$ and $T_{12}$, like the transistors $T_{11}$ and $T_{13}$, have different emitter areas. The ratio between the emitter areas of the transistors $T_{10}$ and $T_{11}$, for example 4, is equal to the ratio between the emitter areas of the transistors $T_{13}$ and $T_{12}$. In comparison with that of Figure 1, such a transconductance amplifier provides a larger range in which the output current increases as a linear function of the input voltage. The common collector current $I_1$ of the transistors $T_{10}$ and $T_{12}$ is applied to a current dividing circuit 13 comprising a diode-connected transistor $T_{14}$ and a transistor $T_{15}$ whose base emitter junction is arranged in parallel with that of transistor $T_{14}$. The ratio between the collector current I, of the transistor $T_{14}$ and the collector current $I_4$ of the transistor $T_{15}$ is determined by the ratio between the emitter areas of these transistors. For example, if the emitter area of transistor $T_{14}$ is twice as large as the emitter area of transistor $T_{15}$, the current $I_3$ will be twice as large as the current $I_4$. The common collector current $I_2$ of the transistors $T_{11}$ and $T_{13}$ is divided into a current $I_5$ and a current $I_6$ by means of a current dividing circuit 14 which comprises the transistors

$T_{16}$ and $T_{17}$ and which is similar to the current dividing circuit 13. The collector current $I_6$ of the transistor $T_{17}$ together with the collector current $I_3$ of transistor $T_{14}$ constitutes the output current $I_7$ and the collector current $I_4$ of transistor $T_{15}$ together with the collector current $I_5$ of transistor $T_{16}$ constitutes the output current $I_8$. For a ratio of two between the emitter areas of the transistors $T_{14}$ and $T_{15}$ the factor $a = \frac{1}{2}$ (see equations 1 and 2). The transconductance is then 1/3 of the transconductance of theoriginal circuit.

The invention is not limited to the present current dividing circuit : Within the scope of the invention any current dividing circuit may be used. For example, the emitter areas of the transistors of a current dividing circuit may be equal and the ratio between the output currents of the current dividing circuit may be adjusted by means of resistors arranged in the emitter lines of the transistors. Furthermore, the invention is not limited to the transconductance amplifiers described above but any other transconductance amplifier with a differential pair may be employed, for example that described in the aforementioned article in Proceedings of ECCTD '83 and that in the IEEE Journal of Solid State Circuits SC-17 713-722 "Integration of analog filters in a bipolar process". Finally, it is to be noted that the use of transconductance amplifiers in accordance with the invention is not limited to integrated filter circuits, but that they may also be used in any other arrangement in which a low transconductance is required.

CLAIMS

1.      A transconductance amplifier comprising at least two transistors which are arranged as a differential amplifier and which are powered by a current source, in which an input voltage is applied between the bases of said transistors and the currents in the collectors of said transistors constitute the output currents of the amplifier, characterized in that the collector currents are each divided into a first current and a second current by means of a current dividing circuit and the second currents are added crosswise to the first currents.

2.      A transconductance amplifier as claimed in Claim 1, characterized in that the current dividing circuits each comprise two transistors with parallel-connected base-emitter junctionsand a common emitter terminal which is connected to the collector of a transistor of the differential amplif er, the collector of one transistor of the current dividing circuit carrying the first current and the collector of the other transistor of the current dividing circuit carrying the second current.

0190469

FIG.1

FIG.2

PHN 11255

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | IEEE JOURNAL OF SOLID-STATE CIRCUITS, vol. SC-12, no. 3, June 1977, IEEE, New York, US; P. GARDE: "Transconductance cancellation for operational amplifiers" * Figure 2, page 311 * | 1 | H 03 F 3/45 |
| A | IEEE INTERNATIONAL SOLID-STATE CIRCUITS CONFERENCE, DIGEST OF TECHNICAL PAPERS, vol. 22, February 1979, IEEE, New York, US; J.C. SCHMOOCK et al.: "Monolithic multiplier/divider" * Figure 5; page 230, right-hand column, line 35 - page 231, left-hand column, line 7 * | 1,2 | |
| A | PATENTS ABSTRACTS OF JAPAN, vol. 3, no. 30, 13th March 1979, page 140 E 97; & JP - A - 54 8952 (SANYO DENKI K.K.) 23-01-1979 | | TECHNICAL FIELDS SEARCHED (Int. Cl.4) H 03 F H 03 G |
| A | EP-A-0 046 878 (LICENTIA PATENT-VERWALTUNGS-GmbH) * Figure 2; page 2, lines 5-13; page 3, line 23 - page 4, line 32 * | 1 | |
| A | US-A-3 979 689 (O.H. SCHADE) * Figure 3; column 5, line 19 - column 7, line 35 * | 2 | |

The present search report has been drawn up for all claims

| Place of search | Date of completion of the search | Examiner |
|---|---|---|
| THE HAGUE | 22-04-1986 | TYBERGHIEN G.M.P. |